(19) Europäisches Patentamt
European Patent Office
Office européen des brevets

(11) **EP 4 276 531 A1**

(12) **EUROPEAN PATENT APPLICATION**
published in accordance with Art. 153(4) EPC

(43) Date of publication:
**15.11.2023 Bulletin 2023/46**

(21) Application number: **21917750.8**

(22) Date of filing: **27.12.2021**

(51) International Patent Classification (IPC):
*G03F 1/24* (2012.01)

(52) Cooperative Patent Classification (CPC):
**G03F 1/24**

(86) International application number:
**PCT/JP2021/048633**

(87) International publication number:
**WO 2022/149530 (14.07.2022 Gazette 2022/28)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **08.01.2021 JP 2021002248**

(71) Applicant: **Toppan Photomask Co., Ltd.
Tokyo 108-0023 (JP)**

(72) Inventors:
• **YAMAGATA, Yuto**
**Tokyo 110-0016 (JP)**
• **GODA, Ayumi**
**Tokyo 110-0016 (JP)**
• **NAKANO, Hideaki**
**Tokyo 110-0016 (JP)**
• **ICHIKAWA, Kenjiro**
**Tokyo 110-0016 (JP)**

(74) Representative: **Hoffmann Eitle
Patent- und Rechtsanwälte PartmbB
Arabellastraße 30
81925 München (DE)**

(54) **REFLECTIVE PHOTOMASK BLANK AND REFLECTIVE PHOTOMASK**

(57) This invention provides a reflective photomask blank and a reflective photomask suppressing or reducing the shadowing effect of a reflective photomask for patterning transfer using a light having a wavelength in the extreme ultraviolet region as a light source and having high interlayer adhesion between a capping layer and a low reflective part. A reflective photomask blank (10) according to this embodiment includes a substrate (1), a reflective part (5), and a low reflective part (4), in which the reflective part (5) includes a multi-layer reflective film (2) and a capping layer (3), the capping layer (3) contains Ru, the low reflective part (4) contains 40 at% or more of a material selected from Ag, Co, In, Pt, Sn, Ni, and Te, and compounds thereof, and a region at least 2 nm thick from the capping layer (3) side of the low reflective part (4) contains 25 at % or more of a material belonging to a first material group or 30 at% or more of a material belonging to a second material group, and the total film thickness of the low reflective part (4) is 45 nm or less.

FIG. 1

## Description

Technical Field

The present invention relates to a reflective photomask used in lithography using a light in the ultraviolet region as a light source and a reflective photomask blank for producing the same.

Background Art

In a manufacturing process of semiconductor devices, a demand for miniaturization by a photolithography technology has increased with the miniaturization of the semiconductor devices. The minimum resolution dimension of a transfer pattern in the photolithography largely depends on the wavelength of an exposure light source, and the minimum resolution dimension can be made smaller as the wavelength is shorter. Therefore, as the exposure light source, a conventional ArF excimer laser light having a wavelength of 193 nm has been replaced with a light in the EUV (Extreme Ultra Violet) region having a wavelength of 13.5 nm.

The light in the EUV region is absorbed by most materials at a high ratio, and therefore a reflective photomask is used as a photomask for EUV exposure (EUV mask) (see PTL 1, for example). PTL 1 discloses an EUV photomask obtained by forming a reflective layer containing a multi-layer film in which molybdenum (Mo) layers and silicon (Si) layers are alternately deposited on a glass substrate, forming an absorption layer containing tantalum (Ta) as the main ingredient on the reflective layer, and forming a pattern on the absorption layer.

Further, in the EUV lithography, a dioptric system utilizing light transmission cannot be used as described above, and therefore an optical system member of an exposure machine is not a lens but a reflective type (mirror). This poses a problem that an incident light and a reflected light on a reflective photomask (EUV mask) cannot be coaxially designed. Thus, in the EUV lithography, a technique is commonly employed which includes making the EUV light incident by tilting the optical axis by 6° from the vertical direction of the EUV mask and guiding a reflected light reflected at an angle of -6° to a semiconductor substrate.

As described above, the optical axis is tilted through the mirror in the EUV lithography, and therefore it is known that a problem referred to as a so-called "shadowing effect" occurs in which the EUV light incident on the EUV mask creates a shadow of a mask pattern (patterned absorption layer) of the EUV mask.

In a current EUV mask blank, a film containing tantalum (Ta) as the main ingredient having a film thickness of 60 nm to 90 nm is used as the absorption layer. When the exposure of the pattern transfer is performed with an EUV mask produced using the mask blank, there is a risk of causing a reduction in the contrast in an edge part to be shadowed by the mask pattern, depending on the relationship between the incident direction of the EUV light and the orientation of the mask pattern. Consequently, problems, such as an increase in line edge roughness of the transfer pattern on the semiconductor substrate and an inability to form a line width with a target dimension, occur, thereby deteriorating the transfer performance in some cases.

Thus, a reflective photomask blank in which a material forming the absorption layer is changed from tantalum (Ta) to a material having high absorptivity (extinction coefficient) to the EUV light and a reflective photomask blank in which a material having high absorptivity to the EUV light is added to tantalum (Ta) have been studied. For example, PTL 2 describes a reflective photomask blank in which the absorption layer is formed of a material containing 50 at% or more of Ta as the main ingredient and further containing at least one element selected from tellurium (Te), antimony (Sb), platinum (Pt), iodine (I), bismuth (Bi), iridium (Ir), osmium (Os), tungsten (W), rhenium (Re), tin (Sn), indium (In), polonium (Po), iron (Fe), gold (Au), mercury (Hg), gallium (Ga), and aluminum (Al).

Further, the mirror is known to be contaminated with by-products (e.g., tin (Sn)) caused by the generation of the EUV, carbon (C) or the like. The accumulation of contaminants on the mirror reduces the reflectance of the mirror surface and reduces the throughput of a lithographic apparatus in some cases. To address this problem, PTL 3 discloses a method for removing the contaminants from the mirror by generating hydrogen radicals in the apparatus and reacting the contaminants with the hydrogen radicals.

The method of PTL 3 also generates hydrogen ions and the like in addition to the hydrogen radicals in the apparatus, however the atomic hydrogen can also enter between a capping layer and a low reflective part in a photomask. The entering atomic hydrogen forms a high hydrogen concentration region between layers, and the atomic hydrogen can form hydrogen molecules by being bonded in this region. The hydrogen molecules thus generated become bubbles to increase the pore density between the layers, and can cause delamination.

To address this problem, a reflective photomask blank has been studied, which prevents the delamination by providing a hydrogen absorption layer between layers that can cause delamination. For example, in a photomask blank described in PTL 4, a technique is disclosed which includes providing a hydrogen absorption layer between a multi-layer reflective film and a capping layer, thereby capturing the atomic hydrogen, which can cause the delamination, in the hydrogen absorption layer.

However, in the reflective photomask blank described in PTL 4, the delamination between the capping layer and the low reflective part is not described. Therefore, a transfer pattern (mask pattern) formed on the absorption layer by the introduction to the EUV exposure apparatus cannot be stably maintained, and as a result, there is a possibility that the transferability deteriorates.

Citation List

Patent Literatures

PTL 1: JP 2011-176162 A
PTL 2: JP 2007-273678 A
PTL 3: JP 2011-530823 A
PTL 4: JP 2019-113825 A

Summary of Invention

Technical Problem

Thus, it is an object of the present invention to provide a reflective photomask blank and a reflective photomask suppressing or reducing the shadowing effect of a reflective photomask for patterning transfer using a light having a wavelength in the extreme ultraviolet region as a light source and having high interlayer adhesion between a capping layer and a low reflective part.

Solution to Problem

To solve the above-described problems, a photomask blank according to one embodiment of the present invention is a reflective photomask blank for producing a reflective photomask for pattern transfer using an extreme ultraviolet light as a light source, and includes: a substrate; a reflective part formed on the substrate and configured to reflect an incident light; and a low reflective part formed on the reflective part and configured to absorb an incident light, in which the reflective part includes a multi-layer reflective film and a capping layer, the capping layer contains at least ruthenium (Ru), the low reflective part contains 40 at% or more of at least one or more materials selected from silver (Ag), cobalt (Co), indium (In), platinum (Pt), tin (Sn), nickel (Ni), and tellurium (Te), and oxides, nitrides, fluorides, borides, oxynitrides, boron oxides, and boron oxynitrides thereof, a region at least 2 nm thick from the capping layer side of the low reflective part contains 25 at% or more of at least one or more materials selected from a first material group consisting of ruthenium (Ru), titanium (Ti), vanadium (V), chromium (Cr), manganese (Mn), iron (Fe), niobium (Nb), molybdenum (Mo), technetium (Tc), rhodium (Rh), tantalum (Ta), tungsten (W), rhenium (Re), osmium (Os), and iridium (Ir), and oxides, nitrides, fluorides, borides, oxynitrides, boron oxides, and boron oxynitrides thereof or contains 30 at% or more of at least one or more materials selected from a second material group consisting of scandium (Sc), copper (Cu), yttrium (Y), zirconium (Zr), palladium (Pd), lanthanum (La), hafnium (Hf), gold (Au), beryllium (Be), magnesium (Mg), calcium (Ca), zinc (Zn), cadmium (Cd), and aluminum (Al), and oxides, nitrides, fluorides, borides, oxynitrides, boron oxides, and boron oxynitrides thereof, and the total film thickness of the low reflective part is 45 nm or less.

To solve the above-described problems, a reflective photomask according to one embodiment of the present invention includes: a substrate; a reflective part formed on the substrate and configured to reflect an incident light; and a low reflective part formed on the reflective part and configured to absorb an incident light, in which the reflective part includes a multi-layer reflective film and a capping layer, the capping layer contains at least ruthenium (Ru), the low reflective part contains 40 at% or more of at least one or more materials selected from silver (Ag), cobalt (Co), indium (In), platinum (Pt), tin (Sn), nickel (Ni), and tellurium (Te), and oxides, nitrides, fluorides, borides, oxynitrides, boron oxides, and boron oxynitrides thereof, a region at least 2 nm thick from the capping layer side of the low reflective part contains 25 at% or more of at least one or more materials selected from a first material group consisting of ruthenium (Ru), titanium (Ti), vanadium (V), chromium (Cr), manganese (Mn), iron (Fe), niobium (Nb), molybdenum (Mo), technetium (Tc), rhodium (Rh), tantalum (Ta), tungsten (W), rhenium (Re), osmium (Os), and iridium (Ir), and oxides, nitrides, fluorides, borides, oxynitrides, boron oxides, and boron oxynitrides thereof or contains 30 at% or more of at least one or more materials selected from a second material group consisting of scandium (Sc), copper (Cu), yttrium (Y), zirconium (Zr), palladium (Pd), lanthanum (La), hafnium (Hf), gold (Au), beryllium (Be), magnesium (Mg), calcium (Ca), zinc (Zn), cadmium (Cd), and aluminum (Al), and oxides, nitrides, fluorides, borides, oxynitrides, boron oxides, and boron oxynitrides thereof, and the total film thickness of the low reflective part is 45 nm or less.

Advantageous Effects of Invention

According to one aspect of the present invention, transfer performance to a semiconductor substrate is improved in patterning using a light having a wavelength in the extreme ultraviolet region as a light source, and resistance to the external environment can be expected when a photomask is manufactured and used. More specifically, the reflective photomask blank and the reflective photomask according to one embodiment of the present invention suppress or reduce the shadowing effect of the reflective photomask for patterning transfer using a light having a wavelength in the extreme ultraviolet region as a light source and have high interlayer adhesion between the capping layer and the low reflective part.

Brief Description of Drawings

FIG. 1 is a schematic cross-sectional view illustrating the structure of a reflective photomask blank according to an embodiment of the present invention;
FIG. 2 is a schematic cross-sectional view illustrating the structure of a reflective photomask according to an embodiment of the present invention;
FIG. 3 is a map illustrating a refractive index n and an extinction coefficient k at the wavelength of an EUV light;
FIG. 4 is a schematic cross-sectional view illustrating the structure of a reflective photomask according to a modification of the embodiment of the present invention;
FIG. 5 is a conceptual view illustrating an example of the content (concentration) distribution of a material belonging to a first material group and the content (concentration) distribution of a high extinction coefficient material in an absorption layer (low reflective part) provided in the reflective photomask blank and the reflective photomask according to the embodiment of the present invention;
FIG. 6 is a conceptual view illustrating an example of the content (concentration) distribution of a material belonging to the first material group and the content (concentration) distribution of a high extinction coefficient material in the absorption layer (low reflective part) provided in the reflective photomask blank and the reflective photomask according to the embodiment of the present invention;
FIG. 7 is a conceptual view illustrating an example of the content (concentration) distribution of a material belonging to the first material group and the content (concentration) distribution of a high extinction coefficient material in the absorption layer (low reflective part) provided in the reflective photomask blank and the reflective photomask according to the embodiment of the present invention;
FIG. 8 is a conceptual view illustrating an example of the content (concentration) distribution of a material belonging to the first material group and the content (concentration) distribution of a high extinction coefficient material in the absorption layer (low reflective part) provided in the reflective photomask blank and the reflective photomask according to the embodiment of the present invention;
FIG. 9 is a schematic cross-sectional view illustrating the structure of the reflective photomask according to the embodiment of the present invention;
FIG. 10 is a schematic cross-sectional view illustrating the structure of a reflective photomask blank according to Examples of the present invention;
FIG. 11 is a schematic cross-sectional view illustrating a manufacturing process of a reflective photomask according to Examples of the present invention;
FIG. 12 is a schematic cross-sectional view illustrating a manufacturing process of the reflective photomask according to Examples of the present invention;
FIG. 13 is a schematic cross-sectional view illustrating a manufacturing process of the reflective photomask according to Examples of the present invention;
FIG. 14 is a schematic cross-sectional view illustrating a manufacturing process of the reflective photomask according to Examples of the present invention;
FIG. 15 is a schematic plan view illustrating an LS pattern with a line width of 64 nm for transfer evaluation according to Examples of the present invention;
FIG. 16 is a schematic cross-sectional view illustrating the structure of a reflective photomask blank according to Examples of the present invention;
FIG. 17 is a schematic cross-sectional view illustrating the structure of a reflective photomask according to Examples of the present invention;
FIG. 18 is a schematic cross-sectional view illustrating the structure of a reflective photomask blank according to Examples of the present invention;
FIG. 19 is a schematic cross-sectional view illustrating the structure of a reflective photomask according to Examples of the present invention;

FIG. 20 is a schematic cross-sectional view illustrating the structure of a reflective photomask blank according to Comparative Example of the present invention;

FIG. 21 is a schematic cross-sectional view illustrating the structure of a reflective photomask according to Comparative Example of the present invention;

FIG. 22 is a conceptual view illustrating an example of the content (concentration) distribution of a material belonging to the first material group and the content (concentration) distribution of a high extinction coefficient material in an absorption layer (low reflective part) provided in a reflective photomask blank and a reflective photomask according to Example of the present invention; and

FIG. 23 is a conceptual view illustrating an example of the content (concentration) distribution of a material belonging to the first material group and the content (concentration) distribution of a high extinction coefficient material in an absorption layer (low reflective part) provided in a reflective photomask blank and a reflective photomask according to Comparative Example of the present invention.

Description of Embodiments

Hereinafter, embodiments of the present invention are described with reference to the drawings, but the present invention is not limited to the following embodiments. In the embodiments described below, a technically preferable limitation is made to implement the present invention, but this limitation is not a requirement of the present invention.

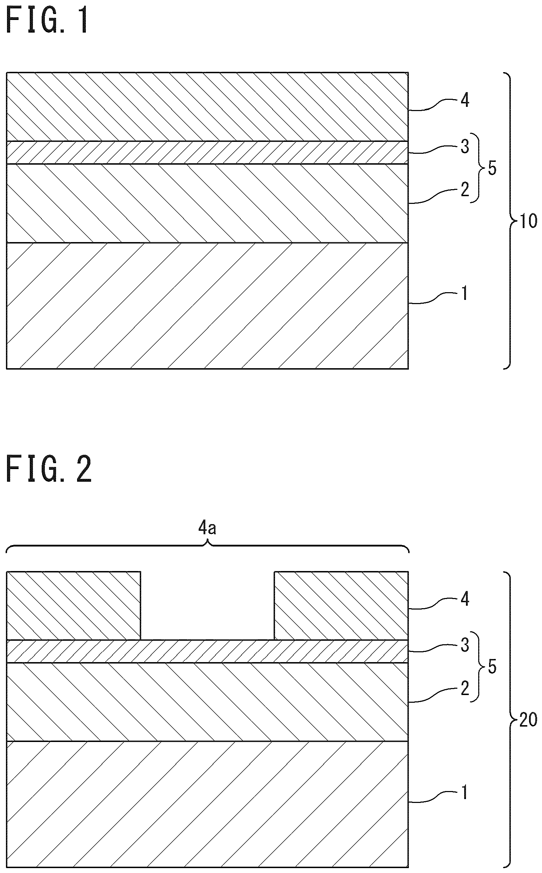

FIG. 1 is a schematic cross-sectional view illustrating the structure of a reflective photomask blank 10 according to an embodiment of the present invention. FIG. 2 is a schematic cross-sectional view illustrating the structure of a reflective photomask 20 according to an embodiment of the present invention. Herein, the reflective photomask 20 according to the embodiment of the present invention illustrated in FIG. 2 is formed by patterning a low reflective part 4 of the reflective photomask blank 10 according to the embodiment of the present invention illustrated in FIG. 1.

(Entire configuration)

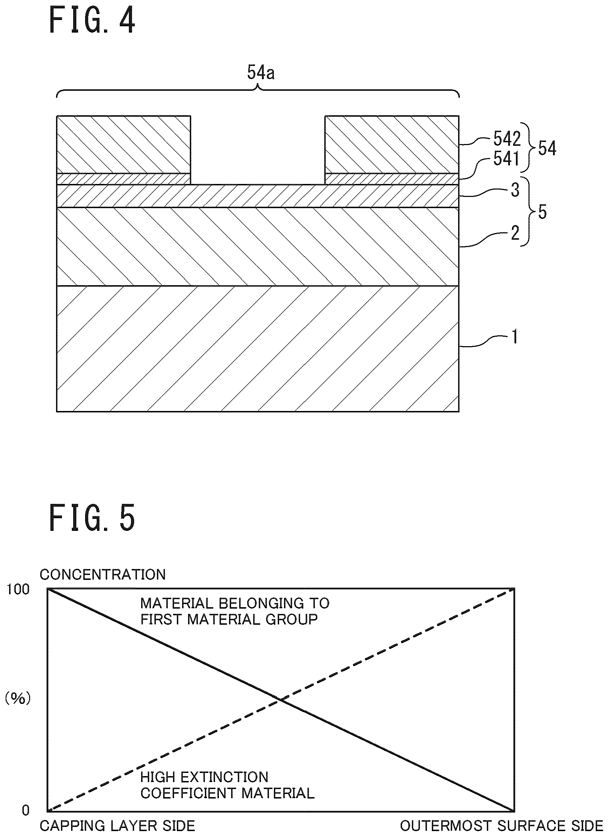

As illustrated in FIG. 1, the reflective photomask blank 10 according to the embodiment of the present invention includes a substrate 1, a multi-layer reflective film 2 formed on the substrate 1, and a capping layer 3 formed on the multi-layer reflective film 2. Thus, a reflective part 5 having the multi-layer reflective film 2 and the capping layer 3 is formed on the substrate 1, and a low reflective part 4 is provided on the reflective part 5. The low reflective part 4 may contain an absorption layer or may contain an adhesion layer and an absorption layer as illustrated in FIG. 4.

(Substrate)

For the substrate 1 according to the embodiment of the present invention, a flat silicon (Si) substrate, a synthetic quartz substrate, or the like is usable, for example. Further, a low thermal expansion glass to which titanium (Ti) is added is usable for the substrate 1. However, this embodiment is not limited to the above, and any material having a small thermal expansion coefficient may be acceptable.

(Multi-layer reflective film)

The multi-layer reflective film 2 according to the embodiment of the present invention may be one reflecting an EUV light (extreme ultraviolet light), which is an exposure light or may be a multi-layer reflective film containing a combination of materials having greatly different refractive indices to the EUV light. As the multi-layer reflective film 2, one formed by repeatedly depositing a layer containing a combination of molybdenum (Mo) and silicon (Si) or molybdenum (Mo) and beryllium (Be) by about 40 cycles may be acceptable, for example.

(Capping layer)

The capping layer 3 according to the embodiment of the present invention is formed of a material having resistance to dry etching performed in forming a transfer pattern (mask pattern) on the low reflective part 4 and functions as an etching stopper to prevent damage to the multi-layer reflective film 2 when the low reflective part 4 is etched. The capping layer 3 is formed of a material containing at least Ru (ruthenium). The content of ruthenium (Ru) in the capping layer 3 is preferably within the range of 30 mass% or more and 100 mass% or less, more preferably within the range of 50 mass% or more and 100 mass% or less, and still more preferably within the range of 80 mass% or more and 100 mass% or less based on the mass of the entire capping layer 3. When the content of ruthenium (Ru) is 30 mass% or more based on the mass of the entire capping layer 3, the above-described function as the etching stopper is further improved.

Although not illustrated in the drawings, a back surface conductive film can be formed on the surface on which the multi-layer reflective film 2 is not formed of the substrate 1. The back surface conductive film is a film for fixing the reflective photomask 20 utilizing the principle of an electrostatic chuck when the reflective photomask 20 is installed in an exposure machine.

(Low reflective part)

As illustrated in FIG. 2, a low reflective part pattern 4a of the reflective photomask 20 is formed by removing a part of the low reflective part 4 of the reflective photomask blank 10, i.e., patterning the low reflective part 4. In the EUV lithography, the EUV light is obliquely incident and reflected by the reflective part 5, but the transfer performance onto a wafer (semiconductor substrate) sometimes deteriorates due to a shadowing effect in which the low reflective pattern 4a interferes with an optical path. This deterioration of the transfer performance is reduced by reducing the thickness of the low reflective part 4 absorbing the EUV light. To reduce the thickness of the low reflective part 4, a material having higher absorptivity to the EUV light than that of a conventional material, i.e., a material having a high extinction coefficient k to a wavelength of 13.5 nm, is preferably applied.

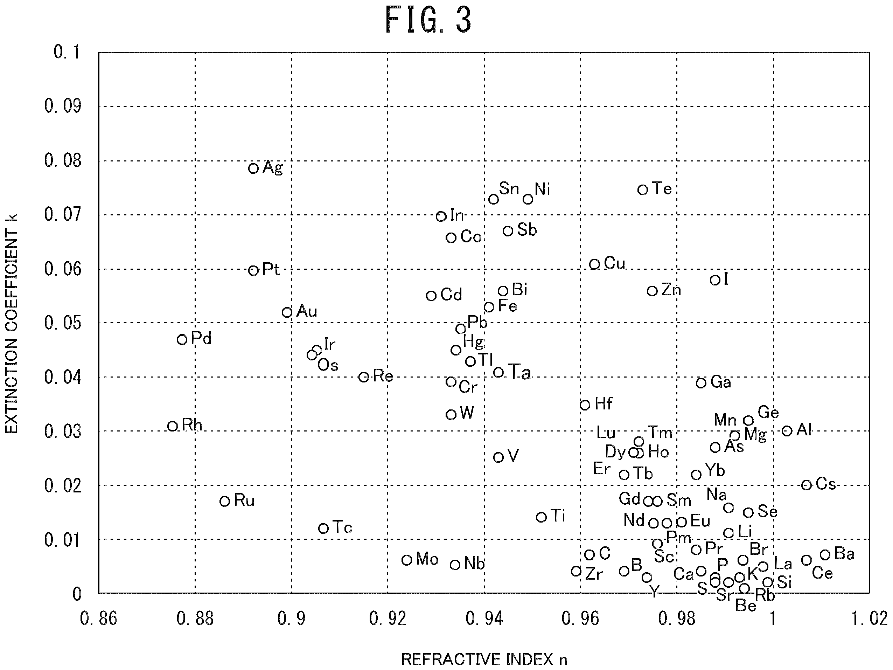

FIG. 3 is a graph showing the optical constants to the wavelength of 13.5 nm of the EUV light of some metal materials. The horizontal axis of FIG. 3 represents the refractive index n and the vertical axis represents the extinction coefficient k. The extinction coefficient k of tantalum (Ta), which is a main material of the conventional low reflective part 4, is 0.041. Materials having a larger extinction coefficient k than 0.041 can reduce the thickness of the low reflective part 4 compared to that of the conventional low reflective part.

Examples of the materials satisfying the extinction coefficient k described above include silver (Ag), platinum (Pt), indium (In), cobalt (Co), tin (Sn), nickel (Ni), and tellurium (Te), as illustrated in FIG. 3.

When the intensity of a reflected light from the reflective part 5 is defined as Rm and the intensity of a reflected light from the low reflective part 4 is defined as Ra, an optical density (OD) value, which is an index representing the light intensity contrast between the reflective part 5 and the low reflective part 4, is defined by Expression (1) below.

$$OD = -\log(Ra/Rm)\cdots \text{Equation (1)}$$

When the OD value is larger, the contrast is better and higher transferability is obtained. Although OD > 1 is required for the pattern transfer, the OD value of 1.5 or more is more preferable as compared with the above-described conventional one.

As described above, compound materials containing Ta as the main ingredient as described above have been applied to the low reflective part 4 of a conventional EUV reflective photomask. In this case, it has been necessary to set the film thickness of the low reflective part 4 to 40 nm or more to obtain the OD value of 1 or more and set the film thickness of the low reflective part 4 to 70 nm or more to obtain the OD value of 2 or more. The extinction coefficient k of tantalum (Ta) is 0.041, while, among the materials illustrated in FIG. 3, silver (Ag), platinum (Pt), indium (In), cobalt (Co), tin (Sn), nickel (Ni), and tellurium (Te) all have the extinction coefficient of 0.041 or more, and therefore the thickness of the film can be further reduced as compared with the case of using tantalum (Ta). In particular, an oxide of tin (Sn) and indium (In) is desirable as a candidate material because the oxide enables etching processing by a chlorine-based gas.

For example, the application of a material containing tin (Sn) having the extinction coefficient k of 0.06 or more and oxygen (O) or a material containing indium (In) and oxygen (O) to the low reflective part 4 enables the reduction in the film thickness of the low reflective part 4 to 17 nm when at least the OD value is 1 or more and enables the reduction in the film thickness of the low reflective part 4 to 45 nm or less when the OD value is 2 or more. However, when the film thickness of the low reflective part 4 exceeds 45 nm, the shadowing effect of the low reflective part 4 is substantially the same as that of the low reflective part 4 having a film thickness of 60 nm formed of the conventional compound material containing Ta as the main ingredient.

Therefore, the low reflective part 4 in the embodiment of the present invention contains at least 40 at% or more of at least one or more materials (hereinafter referred to as high extinction coefficient materials) selected from silver (Ag), cobalt (Co), indium (In), platinum (Pt), tin (Sn), nickel (Ni), and tellurium (Te), and oxides, nitrides, fluorides, borides, oxynitrides, boron oxides, and boron oxynitrides thereof, and has a film thickness of 45 nm or less. More specifically, when the film thickness of the low reflective part 4 is within the range of 45 nm or less, the shadowing effect can be sufficiently reduced and the transfer performance can be further improved as compared with the conventional low reflective part 4 formed of the compound material containing tantalum (Ta) as the main ingredient. Herein, when the content of the above-described high extinction coefficient materials is 40 at% or more based on the number of atoms of the entire low reflective part 4, it becomes easy to set the film thickness of the low reflective part 4 to 45 nm or less. When the content of the high extinction coefficient materials is 75 at% or less based on the number of atoms of the entire low reflective part 4, the adhesion with the capping layer 3 is improved. The content of the above-described high extinction coefficient materials is preferably within the range of 45 at% or more and 65 at% or less and more preferably within the range of 50 at% or more and 60 at% or less based on the number of atoms of the entire low reflective part 4.

Further, to transfer a fine pattern, the contrast of the intensities of a light reflected from the reflective part 5 and a light reflected from the low reflective part 4 is desirably high. Therefore, the OD value of the low reflective part 4 is more preferably 1.5 or more.

Materials belonging to a first material group and materials belonging to a second material group described later satisfy the condition as materials for enhancing the adhesion between the capping layer 3 and the low reflective part 4. This is because the materials belonging to the first material group and the materials belonging to the second material group each have a surface free energy value close to that of ruthenium (Ru) contained in the capping layer 3. In particular, the materials belonging to the first material group have a surface free energy value closer to that of ruthenium (Ru) as compared with the materials belonging to the second material group, and therefore further strengthen the adhesion between the capping layer 3 and the low reflective part 4.

The materials belonging to the first material group are materials having a surface free energy of less than $\pm 0.5$ [J/m$^2$] with the surface free energy of ruthenium (Ru) as a reference. The materials belonging to the second material group are materials having a surface free energy of $\pm 0.5$ [J/m$^2$] or more and less than $\pm 2$ [J/m$^2$] with the surface free energy of ruthenium (Ru) as a reference.

Thus, as a material contained in a region at least 2 nm or more thick from the capping layer 3 side of the low reflective part 4, materials mixed with other materials are usable in addition to the materials belonging to the first material group or the materials belonging to the second material group. Not to lower the adhesion with the capping layer 3, materials are preferable which contain at least one or more materials selected from the first material group or at least one or more materials selected from the second material group in a proportion of at least 25 at% or more or 30 at% or more, respectively. More specifically, it is preferable in this embodiment that 25 at% or more of at least one or more materials selected from the first material group are added or 30 at% or more of at least one or more materials selected from the second material group are added to the region having a thickness up to at least 2 nm from the surface on the capping layer 3 side (back surface) of the low reflective part 4 and that the total film thickness of the low reflective part 4 is 45 nm or less.

The above-described first material group as used herein refer to a material group consisting of ruthenium (Ru), titanium (Ti), vanadium (V), chromium (Cr), manganese (Mn), iron (Fe), niobium (Nb), molybdenum (Mo), technetium (Tc), rhodium (Rh), tantalum (Ta), tungsten (W), rhenium (Re), osmium (Os), and iridium (Ir), and oxides, nitrides, fluorides, borides, oxynitrides, boron oxides, and boron oxynitrides thereof.

The above-described second material group refers to a material group consisting of scandium (Sc), copper (Cu), yttrium (Y), zirconium (Zr), palladium (Pd), lanthanum (La), hafnium (Hf), gold (Au), beryllium (Be), magnesium (Mg), calcium (Ca), zinc (Zn), cadmium (Cd), and aluminum (Al), and oxides, nitrides, fluorides, borides, oxynitrides, boron oxides, and boron oxynitrides thereof.

When the content of at least one or more materials selected from the first material group is 25 at% or more based on the number of atoms of the entire material constituting the region at least 2 nm or more thick from the capping layer 3 side of the low reflective part 4, the adhesion between the capping layer 3 and the low reflective part 4 is further strengthened. The content of at least one or more materials selected from the first material group is preferably 40 at% or more and more preferably 50 at% or more based on the number of atoms of the entire material constituting the region at least 2 nm or more thick from the capping layer 3 side of the low reflective part 4.

When the content of at least one or more materials selected from the second material group is 30 at% or more based on the number of atoms of the entire material constituting the region at least 2 nm or more thick from the capping layer 3 side of the low reflective part 4, the adhesion between the capping layer 3 and the low reflective part 4 is further strengthened. The content of at least one or more materials selected from the second material group is preferably 45 at% or more and more preferably 55 at% or more based on the number of atoms of the entire material constituting the region at least 2 nm or more thick from the capping layer 3 side of the low reflective part 4.

The above-described embodiment gives a description of the case where the content of at least one or more materials selected from the first material group is 25 at% or more based on the number of atoms of the entire material constituting the region at least 2 nm or more thick from the capping layer 3 side of the low reflective part 4 and the case where the content of at least one or more materials selected from the second material group is 30 at% or more based on the number of atoms of the entire material constituting the region at least 2 nm or more thick from the capping layer 3 side of the low reflective part 4, but the present invention is not limited thereto.

For example, the content of at least one or more materials selected from the first material group may be 25 at% or more based on the number of atoms of a material constituting the entire low reflective part 4 containing only the absorption layer, and the content of at least one or more materials selected from the second material group may be 30 at% or more based on the number of atoms of a material constituting the entire low reflective part 4 containing only the absorption layer.

More specifically, when the content of at least one or more materials selected from the first material group is 25 at% or more based on the number of atoms of the entire low reflective part 4, the adhesion between the capping layer 3 and the low reflective part 4 is further strengthened. When the content of at least one or more materials selected from the first material group is 60 at% or less based on the number of atoms of the entire low reflective part 4, there is little possibility that the shadowing effect is adversely affected. The content of at least one or more materials selected from the first material group is preferably within the range of 30 at% or more and 55 at% or less and more preferably within the range of 35 at% or more and 50 at% or less based on the number of atoms of the entire low reflective part 4.

The composition of the second material group in the entire low reflective part 4 is preferably 30 at% or more and 60 at% or less, more preferably within the range of 35 at% or more and 55 at% or less, and most preferably within the range of 40 at% or more and 50 at% or less.

The content of at least one or more materials selected from the first material group may be 25 at% or more based on the number of atoms of a material constituting the entire low reflective part 4 containing the adhesion layer and the absorption layer described later. The content of at least one or more materials selected from the second material group may be 30 at% or more based on the number of atoms of a material constituting the entire low reflective part 4 containing the adhesion layer and the absorption layer described later.

(First form)

A first form in the present embodiment is described with reference to FIG. 2.

To facilitate the etching processability, the absorption layer constituting the low reflective part 4 is effectively a film having a uniform composition.

Therefore, to facilitate the etching processability, the absorption layer is preferably a structural body having a uniform composition containing at least 40 at% or more of one or more materials (high extinction coefficient materials) selected from silver (Ag), cobalt (Co), indium (In), platinum (Pt), tin (Sn), nickel (Ni), and tellurium (Te), and oxides, nitrides, fluorides, borides, oxynitrides, boron oxides, and boron oxynitrides thereof, and at least 25 at% or more of one or more materials selected from the first material group or at least 30 at% or more of one or more materials selected from the second material group, based on the number of atoms of the entire absorption layer.

The absorption layer according to the present embodiment may contain a plurality of layers, and may be provided with a hard mask (HM) layer serving as an etching mask, an AR (antireflection) film for improving the inspection light contrast, or the like on the absorption layer. Even in this case, the total film thickness obtained by summing the film thickness of each layer constituting the absorption layer is preferably 45 nm or less. More specifically, even when the low reflective part 4 includes a single layer, the film thickness thereof is preferably 45 nm or less, and even when the low reflective part 4 is divided into a plurality of layers, the total film thickness thereof is preferably 45 nm or less.

(Second form)

A second form in this embodiment is described with reference to FIG. 4.

To reduce the shadowing effect and prevent the atomic hydrogen from entering between the capping layer and the absorption layer, it is effective to add the material having a high extinction coefficient k to an absorption layer 542 and to provide an adhesion layer 541 for more firm adhesion of the capping layer 3 and the absorption layer 542 as illustrated in FIG. 4. It is desirable that a material forming the adhesion layer 541 is the same as the material forming the absorption layer (low reflective part 4) illustrated in FIG. 1 and has a surface free energy value close to that of ruthenium (Ru) forming the capping layer 3.

Therefore, the adhesion layer 541 preferably has a film thickness of 2 nm or more and 20 nm or less, and contains 25 at% or more of one or more materials selected from the first material group or 30 at% or more of one or more materials selected from the second material group described above.

When the film thickness of the adhesion layer 541 is 2 nm or more, the analysis of constituent elements (content measurement of constituent elements) using a commercially available XPS apparatus can be performed. When the film thickness of the adhesion layer 541 is 20 nm or less, the thickness is sufficiently small as the entire thickness of the low reflective part 54, reducing the possibility of deteriorating the transfer performance (possibility of adversely affecting the shadowing effect).

(Third form)

A third form in this embodiment is described with reference to FIG. 2.

The cross-sectional side wall angle of the absorption layer (low reflective part 4) after the absorption layer (low reflective part 4) is patterned is desirably a rectangular shape close to the perpendicular to the surface of the capping layer 3. When the cross-sectional side wall of the absorption layer (low reflective part 4) has a stepped shape or a tapered shape, there is a concern for deterioration of the transfer performance due to unintended attenuation amplification of an exposure light and a change in the reflected light intensity in a pattern end part. Therefore, it is desirable that there is no step in the cross section of the absorption layer (low reflective part 4) after the absorption layer (low reflective part 4) is patterned.

Therefore, it is desirable that a large amount of the material having a surface free energy value close to that of ruthenium (Ru) forming the capping layer 3 is contained in the region on the capping layer 3 side of the low reflective part 4 and the composition ratio of the material continuously changes to decrease toward a region (outermost surface side) on the opposite side to the capping layer 3 of the low reflective part 4, so that the composition is changed without forming a layer boundary.

Therefore, the capping layer 3 side of the low reflective part 4 is preferably a structural body which contains 25 at% or more of one or more materials selected from the first material group or 30 at% or more of one or more materials selected from the second material group in a film thickness (region) of at least 2 nm or more and in which the composition ratio of the first material group or the second material group continuously changes to be smaller in the region (outermost surface side) on the opposite side to the capping layer 3 than on the capping layer 3 side of the low reflective part 4.

Hereinafter, the distributions of the content (concentration) of the materials belonging to the first material group and the content (concentration) of the high extinction coefficient materials, which "continuously change", in the low reflective part 4 are described. In this embodiment, the distribution of the content (concentration) of the materials belonging to the first material group and the distribution of the content (concentration) of the materials belonging to the second material group are qualitatively the same. Therefore, the description of the distribution of the content (concentration) of the materials belonging to the second material group is omitted herein.

In this embodiment, the content of the materials belonging to the first material group preferably decreases straight (linearly), curvedly (e.g., S-curve), or exponentially from the capping layer 3 side toward the outermost surface side of the low reflective part 4.

In this embodiment, the content of the high extinction coefficient materials preferably increases straight (linearly), curvedly (e.g., S-curve), or exponentially from the capping layer 3 side toward the outermost surface side of the low reflective part 4.

At least either the materials belonging to the first material group or the high extinction coefficient materials preferably has a uniform composition in at least one region of a region on the capping layer 3 side and a region on the outermost surface side of the low reflective part 4. In this embodiment, the "region on the capping layer 3" means a region of a 10% lower layer in the entire capping layer 3, and the "region on the outermost surface side" means a region of a 10% upper layer in the entire low reflective part 4.

A point (position) where the content (concentration) of the materials belonging to the first material group and the content (concentration) of the high extinction coefficient materials become the same may be located on the capping layer 3 side or the outermost surface side of the low reflective part 4 when the low reflective part 4 is divided into two equal parts in the thickness direction.

The region on the capping layer 3 side (region of the 10% lower layer in the entire low reflective part 4) may not contain only the materials belonging to the first material group, and the region on the outermost surface side (region of the 10% upper layer in the entire low reflective part 4) may not contain only the high extinction coefficient materials. More specifically, the region on the capping layer 3 side may contain the high extinction coefficient materials, and the region on the outermost surface side may contain the materials belonging to the first material group.

Hereinafter, the distributions of the content (concentration) of the materials belonging to the first material group and the content (concentration) of the high extinction coefficient materials in the low reflective part 4 are described with reference to FIGS. 5 to 8.

FIGS. 5 to 8 are conceptual views illustrating the content distribution (concentration distribution) of the materials belonging to the first material group and the content distribution (concentration distribution) of the high extinction coefficient materials. In FIGS. 5 to 8, the vertical axis represents the contents (%) of the materials belonging to the first material group and the high extinction coefficient materials in the entire low reflective part 4, and the horizontal axis represents the depth direction of the entire low reflective part 4.

FIG. 5 illustrates a form in which the content (solid line) of the materials belonging to the first material group straight (linearly) decreases from the capping layer 3 side to the outermost surface side of the low reflective part 4 and the content (broken line) of the high extinction coefficient materials straight (linearly) increases from the capping layer 3 side to the outermost surface side of the low reflective part 4.

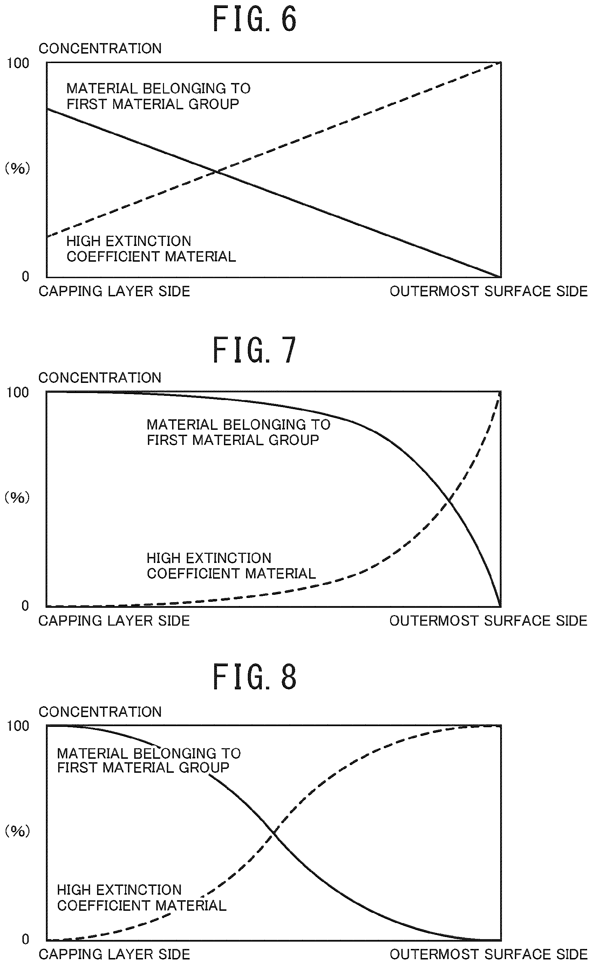

FIG. 6 illustrates a form in which the content (solid line) of the materials belonging to the first material group straight (linearly) decreases from the capping layer 3 side to the outermost surface side of the low reflective part 4 and the content (broken line) of the high extinction coefficient materials straight (linearly) increases from the capping layer 3 side to the outermost surface side of the low reflective part 4, and the point (position) where the content (concentration) of the materials belonging to the first material group and the content (concentration) of the high extinction coefficient materials become the same is located on the capping layer 3 side when the low reflective part 4 is divided into two equal parts in the thickness direction.

FIG. 7 illustrates a form in which the content (solid line) of the materials belonging to the first material group exponentially decreases from the capping layer 3 side to the outermost surface side of the low reflective part 4 and the content (broken line) of the high extinction coefficient materials exponentially increases from the capping layer 3 side to the outermost surface side of the low reflective part 4, the region on the capping layer 3 side and the region on the outermost surface side each have a uniform composition, and the point (position) where the content (concentration) of the materials belonging to the first material group and the content (concentration) of the high extinction coefficient materials become the same is located on the outermost surface side when the low reflective part 4 is divided into two equal parts in the thickness direction.

FIG. 8 illustrates a form in which the content (solid line) of the materials belonging to the first material group curvedly (as if drawing an inverted S-curve) decreases from the capping layer 3 side to the outermost surface side of the low reflective part 4 and the content (broken line) of the high extinction coefficient materials curvedly (as if drawing an S-curve) increases from the capping layer 3 side to the outermost surface side of the low reflective part 4, and the region on the capping layer 3 side and the region on the outermost surface side each have a uniform composition.

In the case of the above-described forms, the low reflective part 4 is provided in which the content of compound materials having high absorptivity to the EUV light (high extinction coefficient materials) increases from the capping layer 3 side toward the outermost surface side of the low reflective part 4, and the content of compound materials having a surface free energy value close to that of ruthenium (Ru) (materials belonging to the first material group or materials belonging to the second material group) contained in the capping layer 3 decreases from the capping layer 3 side toward the outermost surface side of the low reflective part 4, and therefore the shadowing effect decreases and the adhesion between the capping layer 3 and the low reflective part 4 is further strengthened. As a result, a photomask can be produced in which the dimensional accuracy and the shape accuracy of a pattern to be transferred onto a wafer are improved and which is usable for a long period of time.

The distributions of the content of the materials belonging to the first material group and the high extinction coefficient materials in this embodiment are not limited to the distributions described above, and may be distributions obtained by combining the distributions.

Materials constituting the low reflective part 4 contain, for example, beryllium (Be), calcium (Ca), scandium (Sc), vanadium (V), manganese (Mn), iron (Fe), copper (Cu), germanium (Ge), arsenic (As), strontium (Sr), technetium (Tc), rhodium (Rh), barium (Ba), tungsten (W), rhenium (Re), osmium (Os), gold (Au), and the like, and thus can be materials in which the roughness, in-plane dimensional uniformity, and in-plane uniformity of a transferred image are improved and which are sufficiently amorphous.

The materials constituting the low reflective part 4 contain, for example, silver (Ag), cobalt (Co), indium (In), platinum (Pt), tin (Sn), nickel (Ni), tellurium (Te), and the like, and thus can be materials having the extinction coefficient k larger than that of tantalum (Ta), which is a conventional main material.

The materials constituting the low reflective part 4 contain, for example, tantalum (Ta), chromium (Cr), titanium (Ti), aluminum (Al), silicon (Si), zirconium (Zr), vanadium (V), hafnium (Hf), niobium (Nb), yttrium (Y), lead (Pb), gallium (Ga), and the like, and thus can be materials less likely to react with hydrogen radicals and having higher hydrogen radical resistance.

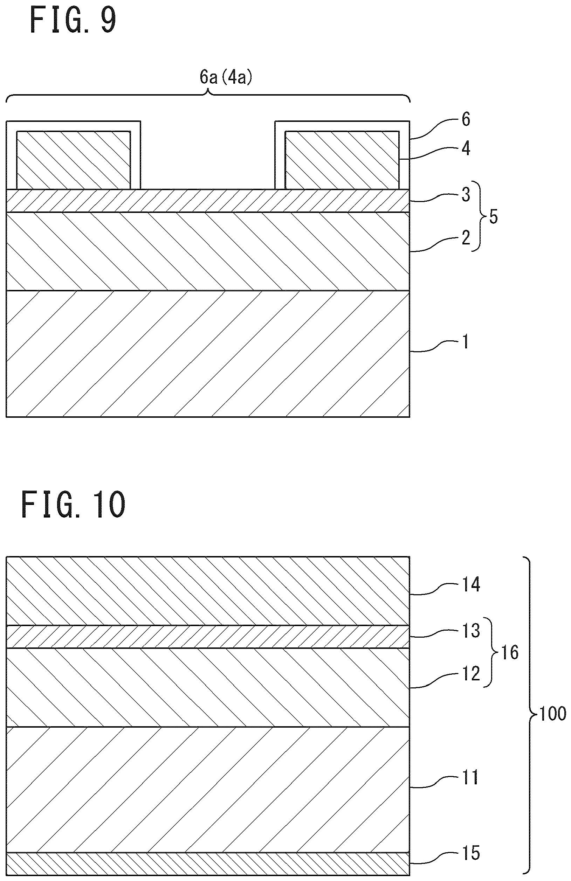

The materials constituting the low reflective part 4 contain, for example, tantalum (Ta), chromium (Cr), titanium (Ti), aluminum (Al), vanadium (V), hafnium (Hf), and the like, and thus an oxide film 6 having hydrogen radical resistance can be formed to cover the exposed surface of the low reflective part 4 as illustrated in FIG. 9.

The materials constituting the low reflective part 4 contain, for example, aluminum (Al), chromium (Cr), zirconium (Zr), and the like, and thus can be materials having low reactivity to chemical solutions, such as SPM and APM, which are generally used for mask cleaning, and having higher cleaning resistance.

The materials constituting the low reflective part 4 contain, for example, silicon nitride (SiN), tantalum oxide (TaO), and the like, and thus can be materials having high optical absorption at a wavelength of 190 nm to 260 nm and inspection light contrast improvability.

The materials constituting the low reflective part 4 contain, for example, cobalt (Co), ruthenium (Ru), iridium (Ir), gold (Au), palladium (Pd), platinum (Pt), molybdenum (Mo), and the like, and thus can be materials having a refractive index n to a wavelength of 13.5 nm of less than 0.95 and improving the phase shift property.

Although examples of the effects of the materials that can be contained in the low reflective part 4 are described above, the effects of the materials are not limited to the examples, and may have two or more of the effects.

The reflective photomask 20 is exposed to an environment in which atomic hydrogen, such as hydrogen radicals or hydrogen ions, is present, and therefore the reflective photomask 20 cannot withstand long-term use unless it is formed of a material having high interlayer adhesion to the atomic hydrogen. In this embodiment, the reflective photomask 20 is exposed to a hydrogen radical-rich environment for a certain period of time by generating hydrogen plasma using a microwave plasma with a power of 1 kw in a vacuum of 0.36 millibar (mbar) or less, and then cut. Then, the cross sections of the capping layer 3 and the low reflective part 4 are observed by transmission electron microscope (TEM).

Thus, a material in which no holes are visually observed is defined as a material having high interlayer adhesion to the atomic hydrogen.

In the TEM observation results of the holes shown in Table 1 described later, as a result of observing a 200 nm area a plurality of times at a magnification of 600000 times, a case where no holes were visually observed was evaluated as "o" and a case where holes were visually observed was evaluated as "×".

Hereinafter, Examples of the reflective photomask blank and the photomask according to the present invention are described.

[Example 1]

As illustrated in FIG. 10, a multi-layer reflective film 12 formed by depositing 40 multi-layer films each containing a pair of silicon (Si) and molybdenum (Mo) is formed on a synthetic quartz substrate 11 having a low thermal expansion property. The film thickness of the multi-layer reflective film 12 was 280 nm.

Next, a capping layer 13 formed of ruthenium (Ru) as an intermediate film was formed to have a film thickness of 2.5 nm on the multi-layer reflective film 12. Thus, a reflective part 16 having the multi-layer reflective film 12 and the capping layer 13 is formed on the substrate 11.

Next, an absorption layer 14 was formed to have a film thickness of 40 nm on the capping layer 13 using a material in which tin oxide (high extinction coefficient material) and tantalum oxide (material belonging to the first material group) were homogeneous in the proportion of 75:25. The atomic number ratio of tin (Sn) and oxygen (O) was 1:2.5 as measured by EDX (energy dispersive X-ray analysis). The crystallinity of the absorption layer 14 was found to be amorphous as measured by XRD (X-ray diffractometer). Thus, the absorption layer 14 is formed on the reflective part 16.

Next, a back surface conductive film 15 formed of chromium nitride was formed with a thickness of 100 nm on the side where the multi-layer reflective film 12 was not formed of the substrate 11 to produce the reflective photomask blank 100 of Example 1.

A multi-source sputtering apparatus was used for the formation of each film on the substrate 11. The film thickness of each film was controlled by a sputtering time.

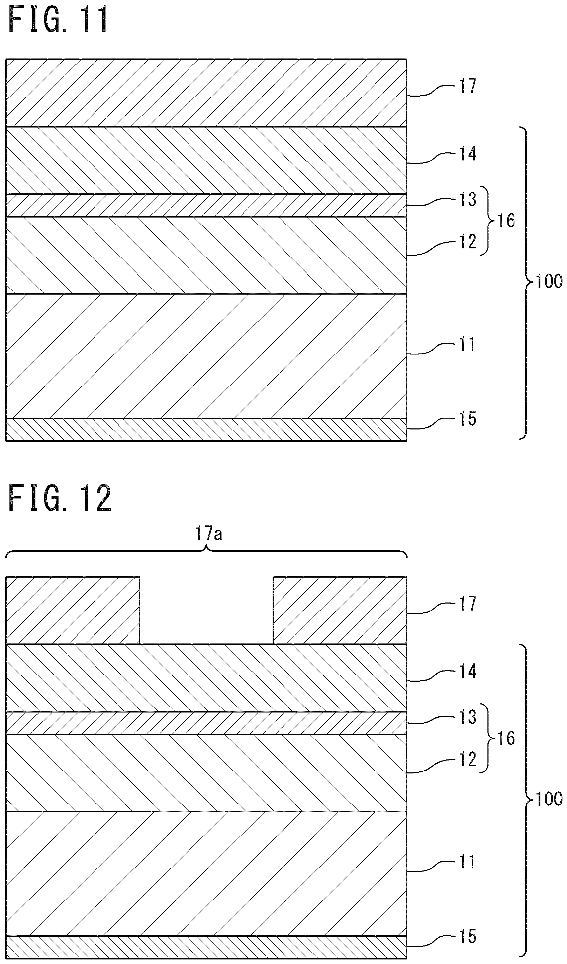

Next, a method for producing a reflective photomask 200 is described using FIGS. 11 to 14.

As illustrated in FIG. 11, a positive chemically amplified resist (SEBP9012: manufactured by Shin-Etsu Chemical Co., Ltd.) was formed on the absorption layer 14 provided in the reflective photomask blank 100 to have a film thickness of 120 nm by spin coating and baked at 110°C for 10 minutes to form a resist film 17.

Next, a predetermined pattern was drawn on the resist film 17 formed of the positive chemically amplified resist by an electron beam drawing machine (JBX3030: manufactured by JEOL Ltd.). Thereafter, baking treatment was performed at 110°C for 10 minutes, and then spray development (SFG3000: manufactured by SIGMAMELTEC LTD.) was performed. Thus, a resist pattern 17a was formed as illustrated in FIG. 12.

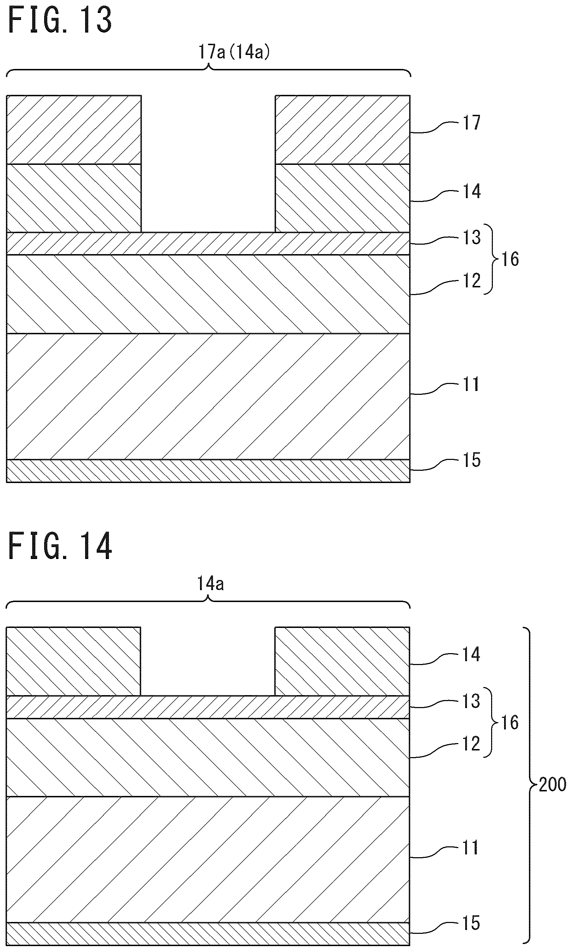

Next, the absorption layer 14 was patterned by dry etching mainly using a chlorine-based gas to form a low reflective part pattern. Thus, a low reflective part pattern 14a was formed as illustrated in FIG. 13.

Next, the remaining resist pattern 17a was peeled off, thereby producing the reflective photomask 200 of this example as illustrated in FIG. 14.

Next, the reflective photomask 200 according to this example was dipped in sulfuric acid at 80°C for 10 minutes, dipped in a cleaning tank filled with a cleaning liquid obtained by mixing 30 mass% of ammonia, hydrogen peroxide water, and water in a ratio of 1:1:20 for 10 minutes using a 500 W megasonic waves, and then cleaned by flowing water for 10 minutes. Thereafter, the film thickness was measured by atomic force microscope (AFM) and compared with the film thickness in the film formation, but no changes in the film thickness were observed.

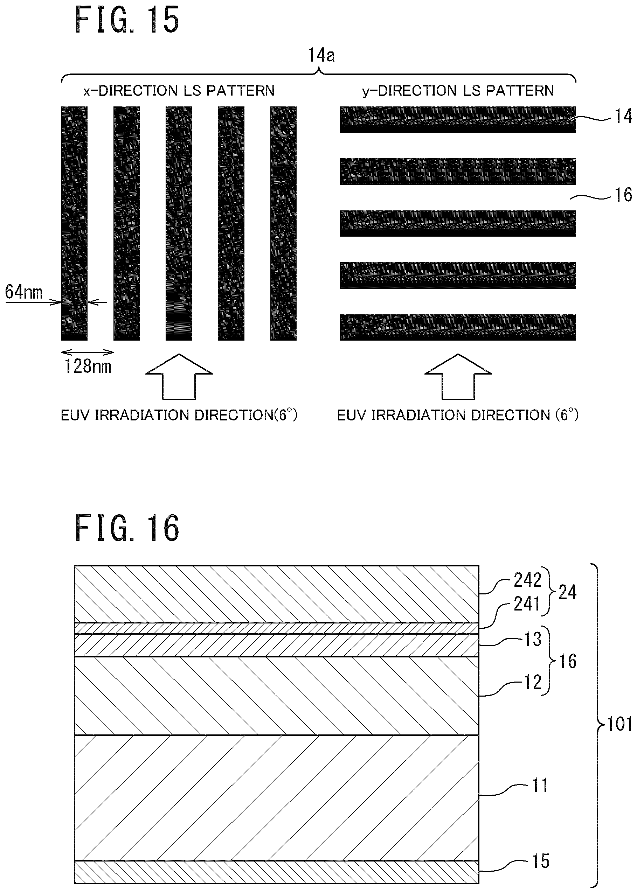

In this example, the low reflective part pattern 14a formed on the absorption layer 14 contains an LS (line and space) pattern with a line width of 64 nm, an LS pattern with a line width of 200 nm for film thickness measurement of the absorption layer 14 using AFM, and a 4 mm square low reflective part removed part for EUV reflectance measurement on the reflective photomask 200 for transfer evaluation. The LS pattern with a line width of 64 nm was designed in each of the x-direction and the y-direction as illustrated in FIG. 15 such that the effect of the shadowing effect by EUV oblique irradiation was able to be easily viewed.

[Example 2]

As illustrated in FIG. 16, an adhesion layer 241 formed of tantalum oxide (material belonging to the first material group) was formed to have a film thickness of 2 nm on the capping layer 13. At this time, the atomic number ratio of tantalum (Ta) and oxygen (O) was found to be 1:1.9 as measured by EDX (energy dispersive X-ray analysis). It was found to be amorphous as measured by XRD (X-ray diffractometer).

Next, an absorption layer 242 formed of tin oxide (high extinction coefficient material) was formed to have a film thickness of 38 nm on the layer formed on the capping layer 13. As a result, the film thickness of the low reflective part 24 was 40 nm in total.

However, with respect to the low reflective part 24, tantalum oxide and tin oxide are separated in the upper layer and the lower layer, and the low reflective part 24 is not a film in which the compositions continuously change.

The atomic number ratio of tin (Sn) and oxygen (O) was 1:2.5 as measured by EDX (energy dispersive X-ray analysis). It was found to be amorphous as measured by XRD (X-ray diffractometer).

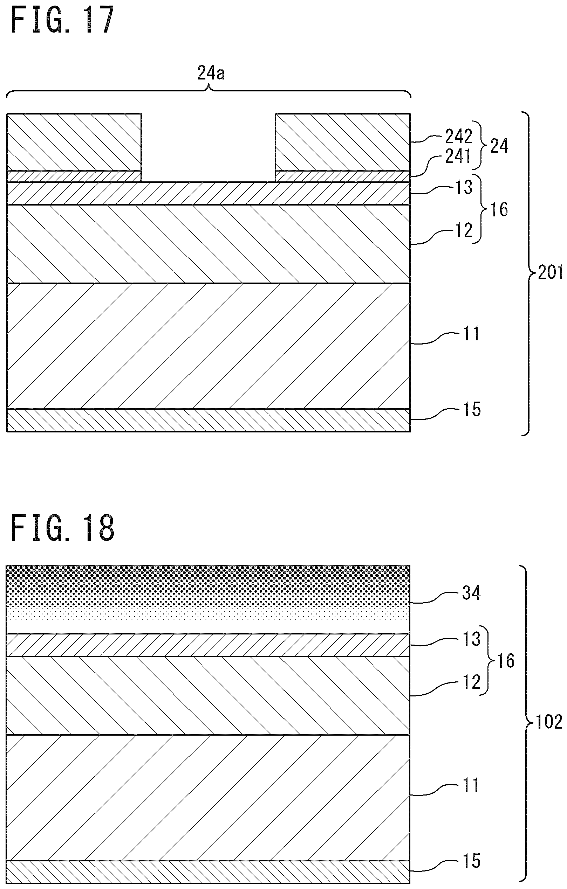

A reflective photomask blank 101 and a reflective photomask 201 including a low reflective part pattern 24a of Example 2 illustrated in FIG. 16 and FIG. 17, respectively, were produced in the same manner as in Example 1, except for the formation of the adhesion layer 241 and the absorption layer 242.

[Example 3]

As illustrated in FIG. 18, a material containing tantalum (Ta) and oxygen (O) was formed into a film to have a film thickness of 2 nm on the capping layer 13. The atomic number ratio of tantalum (Ta) and oxygen (O) was found to be 1:1.9 as measured by EDX (energy dispersive X-ray analysis). It was found to be amorphous as measured by XRD (X-ray diffractometer).

Next, a material containing tantalum (Ta), tin (Sn), and oxygen (O) was formed into a film to have a film thickness of 38 nm on the layer formed on the capping layer 13.

Thus, an absorption layer 34 was formed on the capping layer 13.

The absorption layer 34 was formed by continuously changing the target sputtering voltage not to generate a layer boundary in the film formation.

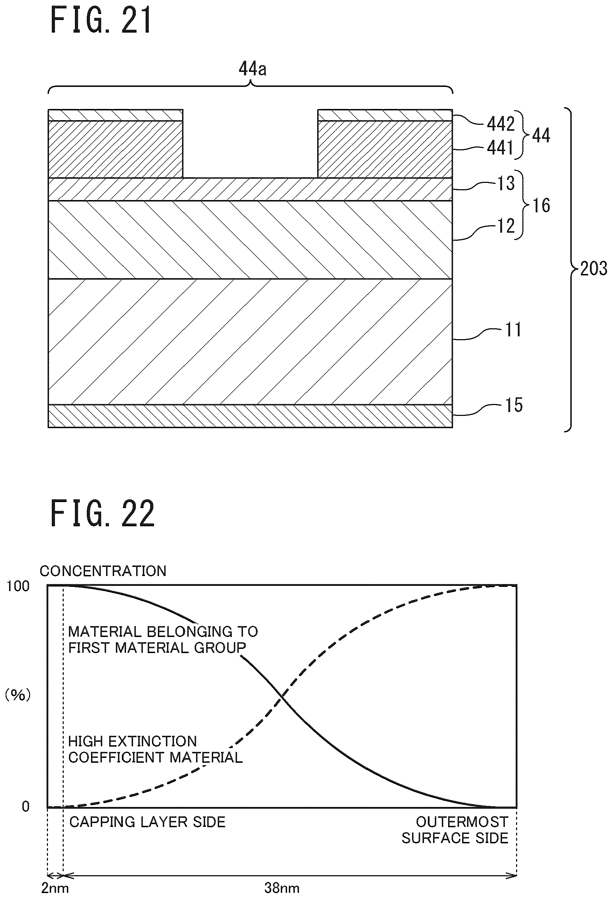

Further, when the composition was analyzed by XPS (X-ray photoelectron spectroscopy), it was found that the composition changes as illustrated in FIG. 22 were observed. More specifically, the contents (solid line) of tantalum (Ta) and oxygen (O) belonging to the first material group are 25 at% or more based on the number of atoms of the entire absorption layer 34 and curvedly (as if drawing an inverted S-curve) decrease from the capping layer 13 side toward the outermost surface side of absorption layer 34, and the contents (broken line) of tin (Sn) and oxygen (O) belonging to the high extinction coefficient materials are 40 at% or more based on the number of atoms of the entire absorption layer 34 and curvedly (as if drawing an S-curve) increase from the capping layer 13 side toward the outermost surface side of the absorption layer 34. Further, the compositions in the region on the capping layer 13 side and the region on the outermost surface side of the absorption layer 34 each are uniform.

However, the depth resolution of the XPS used in this experiment is 2 nm, and therefore the composition changes in the depth direction in the film thickness range of 2 nm on the capping layer 13 side of the absorption layer 34 are unmeasurable.

The atomic number ratio of tantalum (Ta), tin (Sn), and oxygen (O) on the opposite side (outermost surface side) to the capping layer 13 side of the absorption layer 34 was found to be 0:1:1.25 as measured by EDX (energy dispersive X-ray analysis). It was found to be amorphous as measured by XRD (X-ray diffractometer).

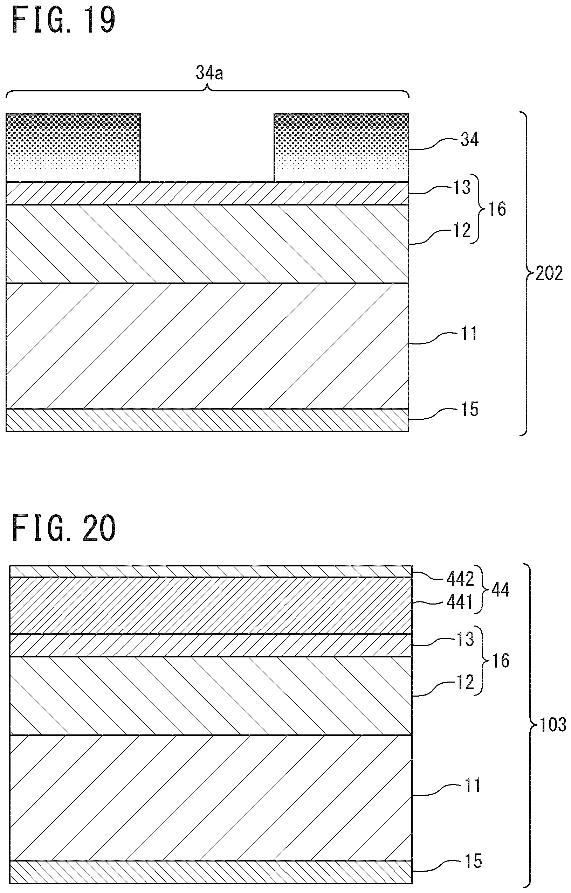

A reflective photomask blank 102 and a reflective photomask 202 including a low reflective part pattern 34a of Example 3 illustrated in FIG. 18 and FIG. 19, respectively, were produced in the same manner as in Example 1, except for the formation of the absorption layer 34.

[Example 4]

The reflective photomask blank 100 and the reflective photomask 200 including the low reflective part pattern 14a of Example 4 illustrated in FIG. 10 and FIG. 14, respectively, were produced in the same manner as in Example 1, except for changing tantalum oxide (material belonging to the first material group) to zirconium oxide (material belonging to the second material group).

The ratio of tin oxide (high extinction coefficient material) and zirconium oxide (material belonging to the second material group) in the absorption layer 14 formed on the capping layer 13 was 75:25. The atomic number ratio of tin (Sn) and oxygen (O) was 1:2.5 as measured by EDX (energy dispersive X-ray analysis). The crystallinity of the absorption layer 14 was found to be amorphous as measured by XRD (X-ray diffractometer).

[Example 5]

The reflective photomask blank 101 and the reflective photomask 201 including the low reflective part pattern 24a of Example 5 illustrated in FIG. 16 and FIG. 17, respectively, were produced in the same manner as in Example 2, except for changing tantalum oxide (material belonging to the first material group) to zirconium oxide (material belonging to the second material group).

The atomic number ratio of zirconium (Zr) and oxygen (O) in the layer formed on the capping layer 13 was 1:1.9 as measured by EDX (energy dispersive X-ray analysis). It was found to be amorphous as measured by XRD (X-ray diffractometer).

Next, the absorption layer 242 formed of tin oxide (high extinction coefficient material) was formed to have a film thickness of 38 nm on the layer formed on the capping layer 13. As a result, the film thickness of the low reflective part 24 was 40 nm in total.

However, with respect to the low reflective part 24, zirconium oxide and tin oxide are separated in the upper layer and the lower layer, and the low reflective part 24 is not a film in which the compositions continuously change.

The atomic number ratio of tin (Sn) and oxygen (O) was 1:2.5 as measured by EDX (energy dispersive X-ray analysis). It was found to be amorphous as measured by XRD (X-ray diffractometer).

[Example 6]

The reflective photomask blank 102 and the reflective photomask 202 including the low reflective part pattern 34a of Example 6 illustrated in FIG. 18 and FIG. 19, respectively, were produced in the same manner as in Example 3, except for changing tantalum oxide (material belonging to the first material group) to zirconium oxide (material belonging to the second material group).

The atomic number ratio of zirconium (Zr) and oxygen (O) in the layer formed on the capping layer 13 was 1:1.9 as measured by EDX (energy dispersive X-ray analysis). It was found to be amorphous as measured by XRD (X-ray diffractometer).

The atomic number ratio of zirconium (Zr), tin (Sn), and oxygen (O) on the opposite side (outermost surface side) to the capping layer 13 side of the absorption layer 34 was found to be 0:1:1.25 as measured by EDX (energy dispersive X-ray analysis). It was found to be amorphous as measured by XRD (X-ray diffractometer).

[Example 7]

The reflective photomask blank 101 and the reflective photomask 201 including the low reflective part pattern 24a of Example 7 illustrated in FIG. 16 and FIG. 17, respectively, were produced in the same manner as in Example 2, except for changing the adhesion layer 241 formed of tantalum oxide (material belonging to the first material group) and having a film thickness of 2 nm to the adhesion layer 241 formed of zirconium oxide (material belonging to the second material group) and having a film thickness of 20 nm.

[Comparative Example 1]

The absorption layer 14 was formed to have a film thickness of 40 nm on the capping layer 13 using a material in which tin oxide (high extinction coefficient material) and tantalum oxide (material belonging to the first material group) were homogeneous in the proportion of 90:10. The atomic number ratio of tin (Sn) and oxygen (O) was 1:2.5 as measured by EDX (energy dispersive X-ray analysis). The crystallinity of the absorption layer 14 was found to be amorphous as measured by XRD (X-ray diffractometer).

The reflective photomask blank 100 and the reflective photomask 200 of Comparative Example 1 illustrated in FIG. 10 and FIG. 14, respectively, were produced in the same manner as in Example 1, except for the formation of the absorption layer 14.

[Comparative Example 2]

The adhesion layer 241 formed of tantalum oxide was formed to have a film thickness of 16 nm on the capping layer 13. At this time, the atomic number ratio of tantalum (Ta) and oxygen (O) was found to be 1:1.9 as measured by EDX (energy dispersive X-ray analysis). It was found to be amorphous as measured by XRD (X-ray diffractometer).

Next, the absorption layer 242 formed of tin oxide was formed to have a film thickness of 36 nm on the layer formed on the capping layer 13. As a result, the film thickness of the low reflective part 24 was 52 nm in total.

However, with respect to the low reflective part 24, tantalum oxide and tin oxide are separated in the upper layer and the lower layer, and the low reflective part 24 is not a film in which the compositions continuously change.

The atomic number ratio of tin (Sn) and oxygen (O) was 1:2.5 as measured by EDX (energy dispersive X-ray analysis). It was found to be amorphous as measured by XRD (X-ray diffractometer).

The reflective photomask blank 101 and the reflective photomask 201 of Comparative Example 2 illustrated in FIG. 16 and FIG. 17, respectively, were produced in the same manner as in Example 1, except for the formation of the adhesion layer 241 and the absorption layer 242.

[Comparative Example 3]

A material containing tantalum (Ta), tin (Sn), and oxygen (O) was formed into a film to have a film thickness of 2 nm on the capping layer 13. The atomic number ratio of tantalum (Ta), tin (Sn), and oxygen (O) was found to be 3.5:25.7:70.8 as measured by EDX (energy dispersive X-ray analysis). It was found to be amorphous as measured by XRD (X-ray diffractometer).

Next, tantalum (Ta), tin (Sn), and oxygen (O) were formed into a film to have a film thickness of 38 nm on the layer formed on the capping layer 13.

Thus, the absorption layer 34 was formed on the capping layer 13.

The absorption layer 34 was formed by continuously changing the target sputtering voltage not to generate a layer boundary in the film formation.

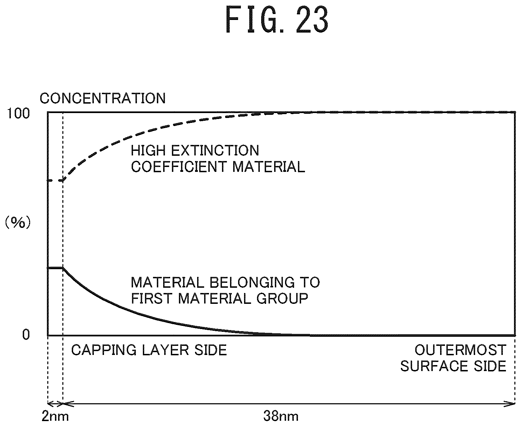

When the composition was analyzed by XPS (X-ray photoelectron spectroscopy), it was found that the composition changes as illustrated in FIG. 23 were observed. More specifically, the contents (solid line) of tantalum (Ta) and oxygen (O) belonging to the first material group are 25 at% or less based on the number of atoms of the entire absorption layer 34. The compositions are uniform in the region on the substrate 11 side and in the region on the outermost surface side of the absorption layer 34.

However, the depth resolution of the XPS used in this experiment is 2 nm, and therefore the composition changes in the depth direction in the film thickness range of 2 nm on the capping layer 13 side of the absorption layer 34 are unmeasurable.

The atomic number ratio of tantalum (Ta), tin (Sn), and oxygen (O) on the opposite side (outermost surface side) to the capping layer 13 side of the absorption layer 34 was found to be 0:1:1.25 as measured by EDX (energy dispersive X-ray analysis). It was found to be amorphous as measured by XRD (X-ray diffractometer).

The reflective photomask blank 102 and the reflective photomask 202 of Comparative Example 3 illustrated in FIG. 18 and FIG. 19, respectively, were produced in the same manner as in Example 1, except for the formation of the absorption layer 34.

[Comparative Example 4]

As illustrated in FIG. 20, an absorption layer 441 was formed of nitrided tantalum to have a film thickness of 58 nm. An outermost layer 442 was formed of tantalum oxide to have a film thickness of 2 nm. This comparative example assumes a reflective photomask using an existing Ta-based film as the main ingredient.

However, tantalum nitride and tantalum oxide are separated in the upper layer and the lower layer, and the film is not a film in which the compositions continuously change.

A reflective photomask blank 103 and a reflective photomask 203 including a low reflective part pattern 44a of Comparative Example 4 illustrated in FIG. 20 and FIG. 21, respectively, were produced in the same manner as in Example 1, except for the formation of the absorption layer 441 and the outermost layer 442.

The reflectance Rm of a reflective part region and the reflectance Ra of a low reflective part region of the reflective photomask produced in each of Examples and Comparative Examples was measured by a reflectance measuring device using the EUV light. The reflectance Rm was measured in the 4 mm square low reflective part removed part. From the measurement results, the OD value was calculated using Equation (1) above.

(Wafer exposure evaluation)

Using an EUV exposure apparatus (NXE3300B: manufactured by ASML), the low reflective part patterns 14a, 24a, 34a, 44a of the reflective photomasks produced in Examples and Comparative Examples each were transferred and exposed onto a semiconductor wafer coated with an EUV positive chemically amplified resist. At this time, the exposure amount was adjusted such that the x-direction LS pattern illustrated in FIG. 15 was transferred as designed. Thereafter, a transferred resist pattern was observed and measured for the line width by an electron beam dimension measuring machine, thereby confirming the resolution.

At this time, a case where the H-Vbias was 6.1 nm of the existing Ta-based film was evaluated as "Δ", a case where the HV-bias was less than 6.1 nm was evaluated as "∘", and a case where the HV-bias was 4.9 nm or less was evaluated as "◎". A case where the OD value was 1.5 or more was evaluated as "o" and a case where the OD value was 2 or more was evaluated as "◎". For the HV-bias, those having the evaluation equal to or higher than "Δ" have no problems in use, and therefore were accepted. For the OD value, those having the evaluation equal to or higher than "∘" have no problems in use, and therefore were accepted.

Table 1 shows these evaluation results.

[Table 1]

| | Absorption layer | | Lower layer of absorption layer | | Low reflective part | Resist pattern on wafer | | Mask characteristics | Determination |
|---|---|---|---|---|---|---|---|---|---|
| | Material | Film thickness | Material | Film thickness | Total film thickness | OD value | Pattern transferability | Interlayer adhesion (TEM observation) | |
| Ex. 1 | Tin oxide, Tantalum oxide (25%) (Mixed) | 40 nm | - | - | 40 nm | ◎ (2.4) | ○ (H-V bias of 5.3 nm) | ○ | ○ |
| Ex. 2 | Tin oxide | 38 nm | Tantalum oxide | 2 nm | 40 nm | ◎ (2.7) | ○ (H-V bias of 5.4 nm) | ○ | ○ |
| Ex. 3 | Tin oxide, Tantalum oxide (Gradient) | 40 nm | - | - | 40 nm | ◎ (2.1) | ◎ (H-V bias of 4.9 nm) | ○ | ◎ |
| Ex. 4 | Tin oxide, Zirconium oxide (25%) (Mixed) | 40 nm | - | - | 40 nm | ○ (1.7) | ◎ (H-V bias of 4.5 nm) | ○ | ○ |
| Ex. 5 | Tin oxide | 38 nm | Zirconium oxide | 2 nm | 40 nm | ◎ (2.6) | ○ (H-V bias of 5.5 nm) | ○ | ○ |
| Ex. 6 | Tin oxide, Zirconium oxide (Gradient) | 40 nm | - | - | 40 nm | ○ (1.6) | ◎ (H-V bias of 4.5 nm) | ○ | ○ |
| Ex. 7 | Tin oxide | 20 nm | Zirconium oxide | 20 nm | 40 nm | ○ (1.7) | ◎ (H-V bias of 4.6 nm) | ○ | ○ |
| Comp. Ex. 1 | Tin oxide, Tantalum oxide (10%) (Mixed) | 40 nm | - | - | 40 nm | ◎ (2.4) | ○ (H-V bias of 5.4 nm) | × | × |
| Comp. Ex. 2 | Tin oxide | 36 nm | Tantalum oxide | 16 nm | 52 nm | ◎ (2.0) | × (H-V bias of 7.6 nm) | ○ | × |
| Comp. Ex. 3 | Tin oxide, Tantalum oxide (10% on substrate side) (Gradient) | 40 nm | - | - | 40 nm | ◎ (2.5) | ○ (H-V bias of 5.4 nm) | × | × |

| | Absorption layer | | Upper layer of absorption layer | | Low reflective part | Resist pattern on wafer | | Mask characteristics | Determination |
|---|---|---|---|---|---|---|---|---|---|
| | Material | Film thickness | Material | Film thickness | Total film thickness | OD value | Pattern transferability | Interlayer adhesion (TEM observation) | |
| Comp. Ex. 4 (Existing Ta-based film) | Tantalum nitride | 58 nm | Tantalum oxide | 2 nm | 60 nm | ○ (1.5) | Δ (H-V bias of 6.1 nm) | ○ | Δ |

Table 1 shows, in Comparative Example 4, the resist pattern dimension on a wafer and the mask characteristics of the photomask having the existing Ta-based film in which the absorption layer 441 contains tantalum nitride and has a film thickness of 58 nm and the outermost layer 442 contains tantalum oxide and has a film thickness of 2 nm. In the reflective photomask 203 of Comparative Example 4, first, there was no vacancies visually observed from the TEM observation of the cross section area, which suggested that the interlayer adhesion was good. Next, the OD value was measured to be 1.5, which suggested that a pattern transferable contrast can be obtained. Finally, the result of EUV light patterning showed that the H-V bias (horizontal-vertical dimensional difference) was 6.1 nm, which suggested that although the pattern was resolved, the transferability was low due to the large influence of the shadowing effect.

Table 1 shows, in Example 1, the resist pattern dimension on a wafer and the mask characteristics in the photomask in which the absorption layer 14 contains a material containing tin oxide and tantalum oxide (mixing ratio: 75:25) and has a film thickness of 40 nm. In the reflective photomask 200 of Example 1, first, there was no vacancies visually observed from the TEM observation results of the mask cross section area, which suggested that the interlayer adhesion was good. Next, the OD value was measured 6to be 2.4, which suggested that a pattern transferable contrast can be obtained. Finally the result of EUV light patterning showed that the H-V bias was 5.3 nm, which suggested that the pattern transferability superior to that of Comparative Example 4 was obtained.

Table 1 shows, in Example 2, the resist pattern dimension on a wafer and the mask characteristics in the photomask in which the absorption layer 242 contains tin oxide and has a film thickness of 38 nm and the adhesion layer 241 contains tantalum oxide and has a film thickness of 2 nm. In the reflective photomask 201 of Example 2, first, there was no vacancies visually observed from the TEM observation results of the mask cross section area, which suggested that the interlayer adhesion was good. Next, the OD value was measured to be 2.7, which suggested that a pattern transferable contrast can be obtained. Finally the result of EUV light patterning showed that the H-V bias was 5.4 nm, which suggested that the pattern transferability superior to that of Comparative Example 4 was obtained.

Table 1 shows, in Example 3, the resist pattern dimension on a wafer and the mask characteristics in the photomask in which the absorption layer 34 having a total film thickness of 40 nm was formed on the capping layer 13 by forming the layer having a film thickness of 2 nm using tantalum oxide on the capping layer 13, and forming the layer having a film thickness of 38 nm using the material containing tantalum (Ta), tin (Sn), and oxygen (O) on the layer formed on the capping layer 13 by continuously changing the target sputtering voltage. In the reflective photomask 202 of Example 3, first, there was no vacancies visually observed from the TEM observation results of the mask cross section area, which suggested that the interlayer adhesion was good. Next, the OD value was measured to be 2.1, which suggested that the pattern transferable contrast can be obtained. Finally the result of EUV light patterning showed that the H-V bias was 4.9 nm, which suggested that the pattern transferability superior to that of Comparative Example 4 was obtained.

Table 1 shows, in Example 4, the resist pattern dimension on a wafer and the mask characteristics in the photomask in which the absorption layer 14 contains a material containing tin oxide and zirconium oxide (mixing ratio: 75:25) and has a film thickness of 40 nm. In the the reflective photomask 200 of Example 4, first, there was no vacancies visually observed from the TEM observation results of the mask cross section area, which suggested that the interlayer adhesion was good. Next, the OD value was measured to be 1.7, which suggested that a pattern transferable contrast can be obtained. Finally, the result of EUV light patterning showed that the H-V bias was 4.5 nm, which suggested that the pattern transferability superior to that of Comparative Example 4 was obtained.

Table 1 shows, in Example 5, the resist pattern dimension on a wafer and the mask characteristics in the photomask in which the absorption layer 242 contains tin oxide and has a film thickness of 38 nm and the adhesion layer 241 contains zirconium oxide and has a film thickness of 2 nm. In the reflective photomask 201 of Example 5, first, there was no vacancies visually observed from the TEM observation results of the mask cross section area, which suggested that the interlayer adhesion was good. Next, the OD value was measured to be 2.6, which suggested that a pattern transferable contrast can be obtained. Finally the result of EUV light patterning showed that the H-V bias was 5.5 nm, which suggested that the pattern transferability superior to that of Comparative Example 4 was obtained.

Table 1 shows, in Example 6, the resist pattern dimension on a wafer and the mask characteristics in the photomask in which the absorption layer 34 having a total film thickness of 40 nm was formed on the capping layer 13 by forming the layer having a film thickness of 2 nm using zirconium oxide on the capping layer 13, and forming the layer having a film thickness of 38 nm using the material containing zirconium (Zr), tin (Sn), and oxygen (O) on the layer formed on the capping layer 13 by continuously changing the target sputtering voltage. In the reflective photomask 202 of Example 6, first, there was no vacancies visually observed from the TEM observation results of the mask cross section area, which suggested that the interlayer adhesion was good. Next, the OD value was measured to be 1.6, which suggested that a pattern transferable contrast can be obtained. Finally, the result of EUV light patterning showed that the H-V bias was 4.5 nm, which suggested the pattern transferability superior to that of Comparative Example 4 was obtained.

Table 1 shows, in Example 7, the resist pattern dimension on a wafer and the mask characteristics in the photomask in which the absorption layer 242 contains tin oxide and has a film thickness of 20 nm and the adhesion layer 241 contains zirconium oxide and has a film thickness of 20 nm. In the reflective photomask 201 of Example 7, first, there was no vacancies visually observed from the TEM observation results of the mask cross section area, which suggested that the interlayer adhesion was good. Next, the OD value was measured to be 1.7, which suggested that a pattern contrastable transferable contrast can be obtained. Finally, the result of EUV light patterning showed that the H-V bias was 4.6 nm, which suggested the pattern transferability superior to that of Comparative Example 4 was obtained.

Table 1 shows, in Comparative Example 1, the resist pattern dimension on a wafer and the mask characteristics in the photomask in which the absorption layer 14 contains the material containing tin oxide and tantalum oxide (mixing ratio: 90:10) and has a film thickness of 40 nm. In the reflective photomask 200 of Comparative Example 1, first, there were vacancies visually observed from the TEM observation results of the mask cross section area, which suggested that the interlayer adhesion was not good. Next, the OD value was measured to be 2.4, which suggested that a pattern transferable contrast can be obtained. Finally the result of EUV light patterning showed that the H-V bias was 5.4 nm, which suggested that the pattern transferability superior to that of Comparative Example 4 was obtained.

Table 1 shows, in Comparative Example 2, the resist pattern dimension on a wafer and the mask characteristics in the photomask in which the absorption layer 242 contains tin oxide and has a film thickness of 36 nm and the adhesion layer 241 contains tantalum oxide and has a film thickness of 16 nm. In the reflective photomask 201 of Comparative Example 2, first, there was no vacancies visually observed from the TEM observation results of the mask cross section area, which suggested the interlayer adhesion was good. Next, the OD value was measured to be 2.0, which suggested that a pattern transferable contrast can be obtained. Finally, the result of EUV light patterning showed that the H-V bias was 7.6 nm, which suggested that the pattern transferability inferior to that of Comparative Example 4 was obtained.

Table 1 shows, in Comparative Example 3, the resist pattern dimension on a wafer and the mask characteristics in the photomask in which the absorption layer 34 having a total film thickness of 40 nm was formed on the capping layer 13 by forming the layer having a film thickness of 2 nm using the material containing tantalum (Ta), tin (Sn), and oxygen (O) (3.5:25.7:70.8) on the capping layer 13, and forming the layer having a film thickness of 38 nm using the material containing tantalum (Ta), tin (Sn), and oxygen (O) on the layer formed on the capping layer 13 by continuously changing the target sputtering voltage. In the reflective photomask 202 of Comparative Example 3, first, there were vacancies visually observed from the TEM observation results of the mask cross section area, which suggested that the interlayer adhesion was not good. Next, the OD value was measured to be 2.5, which suggested that a pattern transferable contrast can be obtained. Finally, the result of EUV light patterning showed that the H-V bias was 5.4 nm, which suggested that the pattern transferability superior to that of Comparative Example 4 was obtained.

Comparing Examples 1 to 7 with the existing Ta-based film (Comparative Example 4), the adhesion of the reflective photomask of each of Examples 1 to 7 was substantially the same as that of the reflective photomask using the existing Ta-based film, and the pattern transferability was able to be improved. The reflective photomasks of Examples 1 to 7 are superior in both the adhesion and the pattern transferability to those of the existing Ta-based film (Comparative Example 4), and therefore the determination results are indicated as "○", "◎" and treated as "pass". The reflective photomasks of Comparative Example 1 to 3 are inferior in either the adhesion or the pattern transferability to that of the existing Ta-based film (Comparative Example 4), and therefore the determination results were indicated as "x" and treated as "failure".

Thus, a result was obtained that the reflective photomask has the low reflective part including the absorption layer containing the material having a high k value or the like on the capping layer containing at least ruthenium (Ru) and has the material having a surface free energy value close to that of ruthenium (Ru) in the region at least 2 nm thick from the capping layer side of the low reflective part is excellent in transferability and irradiation resistance, reduces the shadowing effect, and has a long life and high transfer performance. More specifically, the reflective photomask has the low reflective part including the absorption layer containing the material having a high k value or the like on the capping layer containing at least ruthenium (Ru) and has the material having a surface free energy value close to that of ruthenium (Ru) in the region at least 2 nm thick from the capping layer side of the low reflective part has properties of suppressing or reducing the shadowing effect and strengthening the interlayer adhesion between the capping layer and the low reflective part

Industrial Applicability

The reflective photomask blank and the reflective photomask according to the present invention can be suitably used for forming a fine pattern by EUV exposure in a manufacturing process of a semiconductor integrated circuit and the like.

Reference Signs List

| | |
|---|---|
| 1 | substrate |
| 2 | multi-layer reflective film |
| 3 | capping layer |
| 4 | low reflective part |
| 4a | low reflective part pattern (absorption pattern) |
| 5 | reflective part |
| 6 | oxide film |
| 10 | reflective photomask blank |
| 20 | reflective photomask |
| 11 | substrate |
| 12 | multi-layer reflective film |
| 13 | capping layer |
| 14 | absorption layer (low reflective part) |
| 14a | low reflective part pattern (absorption pattern) |
| 24 | low reflective part |
| 241 | adhesion layer |
| 242 | absorption layer |
| 24a | low reflective part pattern |
| 34 | absorption layer (low reflective part) |
| 34a | low reflective part pattern (absorption pattern) |
| 44 | low reflective part |
| 441 | absorption layer |
| 442 | outermost layer |
| 44a | low reflective part pattern |
| 54 | low reflective part |
| 541 | adhesion layer |
| 542 | absorption layer |
| 54a | low reflective part pattern |
| 15 | back surface conductive film |
| 16 | reflective part |
| 17 | resist film |
| 17a | resist pattern |
| 100 | reflective photomask blank |
| 200 | reflective photomask |
| 101 | reflective photomask blank |
| 201 | reflective photomask |
| 102 | reflective photomask blank |
| 202 | reflective photomask |
| 103 | reflective photomask blank |
| 203 | reflective photomask |

**Claims**

1. A reflective photomask blank for producing a reflective photomask for pattern transfer using an extreme ultraviolet light as a light source, comprising:

   a substrate;
   a reflective part formed on the substrate and configured to reflect an incident light; and
   a low reflective part formed on the reflective part and configured to absorb an incident light, wherein
   the reflective part includes a multi-layer reflective film and a capping layer,
   the capping layer contains at least ruthenium (Ru),
   the low reflective part contains 40 at% or more of at least one or more materials selected from silver (Ag), cobalt (Co), indium (In), platinum (Pt), tin (Sn), nickel (Ni), and tellurium (Te), and oxides, nitrides, fluorides, borides, oxynitrides, boron oxides, and boron oxynitrides of silver (Ag), cobalt (Co), indium (In), platinum (Pt), tin (Sn), nickel (Ni), or tellurium (Te),
   a region at least 2 nm thick from a side of the capping layer of the low reflective part contains 25 at% or more of at least one or more materials selected from a first material group consisting of ruthenium (Ru), titanium (Ti),

19

vanadium (V), chromium (Cr), manganese (Mn), iron (Fe), niobium (Nb), molybdenum (Mo), technetium (Tc), rhodium (Rh), tantalum (Ta), tungsten (W), rhenium (Re), osmium (Os), and iridium (Ir), and oxides, nitrides, fluorides, borides, oxynitrides, boron oxides, and boron oxynitrides of ruthenium (Ru), titanium (Ti), vanadium (V), chromium (Cr), manganese (Mn), iron (Fe), niobium (Nb), molybdenum (Mo), technetium (Tc), rhodium (Rh), tantalum (Ta), tungsten (W), rhenium (Re), osmium (Os), or iridium (Ir) or

contains 30 at% or more of at least one or more materials selected from a second material group consisting of scandium (Sc), copper (Cu), yttrium (Y), zirconium (Zr), palladium (Pd), lanthanum (La), hafnium (Hf), gold (Au), beryllium (Be), magnesium (Mg), calcium (Ca), zinc (Zn), cadmium (Cd), and aluminum (Al), and oxides, nitrides, fluorides, borides, oxynitrides, boron oxides, and boron oxynitrides of scandium (Sc), copper (Cu), yttrium (Y), zirconium (Zr), palladium (Pd), lanthanum (La), hafnium (Hf), gold (Au), beryllium (Be), magnesium (Mg), calcium (Ca), zinc (Zn), cadmium (Cd), and aluminum (Al), and

a total film thickness of the low reflective part is 45 nm or less.

2. The reflective photomask blank according to claim 1, wherein

the low reflective part includes an absorption layer formed on the capping layer or includes an adhesion layer formed on the capping layer and an absorption layer formed on the adhesion layer, the absorption layer contains 40 at% or more of at least one or more materials selected from silver (Ag), cobalt (Co), indium (In), platinum (Pt), tin (Sn), nickel (Ni), and tellurium (Te), and oxides, nitrides, fluorides, borides, oxynitrides, boron oxides, and boron oxynitrides of silver (Ag), cobalt (Co), indium (In), platinum (Pt), tin (Sn), nickel (Ni), or tellurium (Te), and

the absorption layer and the adhesion layer contain 25 at% or more of at least one or more materials selected from the first material group or

contains 30 at% or more of at least one or materials selected from the second material group.

3. The reflective photomask blank according to claim 1 or 2, wherein

the low reflective part has a film thickness of 45 nm or less even when the low reflective part contains a single layer, and

the low reflective part contains 25 at% or more of at least one or more materials selected from the first material group or

contains 30 at% or more of at least one or more materials selected from the second material group.

4. The reflective photomask blank according to claim 1 or 2, wherein

the low reflective part has a total film thickness of 45 nm or less even when the low reflective part is divided into a plurality of layers,

the adhesion layer provided on the side of the capping layer of the low reflective part has a film thickness within a range of 2 nm or more and 20 nm or less, and

the adhesion layer contains 25 at% or more of at least one or more materials selected from the first material group or

contains 30 at% or more of at least one or more materials selected from the second material group.

5. The reflective photomask blank according to any one of claims 1 to 4, wherein the low reflective part is a structural body in which a composition ratio of the first material group or the second material group continuously changes to decrease from the side of the capping layer toward an opposite side to the side of the capping layer.

6. A reflective photomask comprising:

a substrate;
a reflective part formed on the substrate and configured to reflect an incident light; and
a low reflective part formed on the reflective part and configured to absorb an incident light, wherein
the reflective part includes a multi-layer reflective film and a capping layer,
the capping layer contains at least ruthenium (Ru),
the low reflective part contains 40 at% or more of at least one or more materials selected from silver (Ag), cobalt (Co), indium (In), platinum (Pt), tin (Sn), nickel (Ni), and tellurium (Te), and oxides, nitrides, fluorides, borides, oxynitrides, boron oxides, and boron oxynitrides of silver (Ag), cobalt (Co), indium (In), platinum (Pt), tin (Sn), nickel (Ni), or tellurium (Te),

a region at least 2 nm thick from a side of the capping layer of the low reflective part contains 25 at% or more of at least one or more materials selected from a first material group consisting of ruthenium (Ru), titanium (Ti), vanadium (V), chromium (Cr), manganese (Mn), iron (Fe), niobium (Nb), molybdenum (Mo), technetium (Tc), rhodium (Rh), tantalum (Ta), tungsten (W), rhenium (Re), osmium (Os), and iridium (Ir), and oxides, nitrides, fluorides, borides, oxynitrides, boron oxides, and boron oxynitrides of ruthenium (Ru), titanium (Ti), vanadium (V), chromium (Cr), manganese (Mn), iron (Fe), niobium (Nb), molybdenum (Mo), technetium (Tc), rhodium (Rh), tantalum (Ta), tungsten (W), rhenium (Re), osmium (Os), or iridium (Ir) or
contains 30 at% or more of at least one or more materials selected from a second material group consisting of scandium (Sc), copper (Cu), yttrium (Y), zirconium (Zr), palladium (Pd), lanthanum (La), hafnium (Hf), gold (Au), beryllium (Be), magnesium (Mg), calcium (Ca), zinc (Zn), cadmium (Cd), and aluminum (Al), and oxides, nitrides, fluorides, borides, oxynitrides, boron oxides, and boron oxynitrides of scandium (Sc), copper (Cu), yttrium (Y), zirconium (Zr), palladium (Pd), lanthanum (La), hafnium (Hf), gold (Au), beryllium (Be), magnesium (Mg), calcium (Ca), zinc (Zn), cadmium (Cd), or aluminum (Al), and
a total film thickness of the low reflective part is 45 nm or less.

7. The reflective photomask according to claim 6, wherein

the low reflective part includes an absorption layer formed on the capping layer or includes an adhesion layer formed on the capping layer and an absorption layer formed on the adhesion layer,
the absorption layer contains 40 at% or more of at least one or more materials selected from silver (Ag), cobalt (Co), indium (In), platinum (Pt), tin (Sn), nickel (Ni), and tellurium (Te), and oxides, nitrides, fluorides, borides, oxynitrides, boron oxides, and boron oxynitrides of silver (Ag), cobalt (Co), indium (In), platinum (Pt), tin (Sn), nickel (Ni), or tellurium (Te), and
the absorption layer and the adhesion layer contain 25 at% or more of at least one or more materials selected from the first material group or
contain 30 at% or more of at least one or materials selected from the second material group.

8. The reflective photomask according to claim 6 or 7, wherein

the low reflective part has a film thickness of 45 nm or less even when the low reflective part contains a single layer, and
the low reflective part contains 25 at% or more of at least one or more materials selected from the first material group or
contains 30 at% or more of at least one or more materials selected from the second material group.

9. The reflective photomask according to claim 6 or 7, wherein

the low reflective part has a total film thickness of 45 nm or less even when the low reflective part is divided into a plurality of layers,
the adhesion layer provided on the side of the capping layer of the low reflective part has a film thickness within a range of 2 nm or more and 20 nm or less, and
the adhesion layer contains 25 at% or more of at least one or more materials selected from the first material group or
contains 30 at% or more of at least one or more materials selected from the second material group.

10. The reflective photomask according to any one of claims 6 to 9, wherein the low reflective part is a structural body in which a composition ratio of the first material group or the second material group continuously changes to decrease from the side of the capping layer toward an opposite side to the side of the capping layer.

FIG. 1

FIG. 2

# FIG. 3

EP 4 276 531 A1

# FIG. 4

# FIG. 5

# FIG. 6

# FIG. 7

# FIG. 8

# FIG. 9

# FIG. 10

## FIG. 11

(図)

17 — 17
14 — 14
13 — 13
12 — 12 } 16
11 — 11
15 — 15 } 100

## FIG. 12

17a

17 — 17
14 — 14
13 — 13
12 — 12 } 16
11 — 11
15 — 15 } 100

## FIG. 13

17a(14a)

— 17

— 14

— 13  } 16
— 12  }

— 11

— 15

## FIG. 14

14a

— 14

— 13  } 16
— 12  }

— 11

— 15

200

# FIG. 15

14a

x-DIRECTION LS PATTERN                    y-DIRECTION LS PATTERN

14

16

64nm

128nm

EUV IRRADIATION DIRECTION(6°)    EUV IRRADIATION DIRECTION (6°)

# FIG. 16

242 } 24
241
13 } 16
12
101
11
15

## FIG. 17

## FIG. 18

## FIG. 19

## FIG. 20

# FIG. 21

# FIG. 22

# FIG. 23

CONCENTRATION

100

HIGH EXTINCTION
COEFFICIENT MATERIAL

(%)

MATERIAL BELONGING TO
FIRST MATERIAL GROUP

0

CAPPING LAYER SIDE                                    OUTERMOST
                                                      SURFACE SIDE

2nm                              38nm

## INTERNATIONAL SEARCH REPORT

| | International application No. |
| --- | --- |
| | **PCT/JP2021/048633** |

**A. CLASSIFICATION OF SUBJECT MATTER**

*G03F 1/24*(2012.01)i
FI: G03F1/24

According to International Patent Classification (IPC) or to both national classification and IPC

**B. FIELDS SEARCHED**

Minimum documentation searched (classification system followed by classification symbols)

G03F1/24

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2020-197606 A (TOPPAN PRINTING CO LTD) 10 December 2020 (2020-12-10)<br>paragraphs [0035]-[0037], fig. 4 | 1-10 |
| A | US 2019/0146331 A1 (TAIWAN SEMICONDUCTOR MANUFACTURING CO.,LTD.,) 16 May 2019 (2019-05-16)<br>paragraphs [0054]-[0058], fig. 3 | 1-10 |
| A | WO 2019/009211 A1 (TOPPAN PRINTING CO LTD) 10 January 2019 (2019-01-10)<br>paragraphs [0041]-[0042], fig. 11 | 1-10 |
| A | JP 2011-35104 A (ASAHI GLASS CO LTD) 17 February 2011 (2011-02-17)<br>paragraphs [0030]-[0035], fig. 1-2 | 1-10 |
| A | JP 2008-118143 A (HOYA CORP) 22 May 2008 (2008-05-22)<br>paragraphs [0020]-[0028], fig. 1-2 | 1-10 |

☐ Further documents are listed in the continuation of Box C. ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **28 February 2022** | **15 March 2022** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2021/048633**

| Patent document cited in search report | | | Publication date (day/month/year) | Patent family member(s) | | | Publication date (day/month/year) |
|---|---|---|---|---|---|---|---|
| JP | 2020-197606 | A | 10 December 2020 | WO | 2020/241780 | A1 | |
| US | 2019/0146331 | A1 | 16 May 2019 | CN | 109782524 | A | |
| | | | | TW | 201923441 | A | |
| WO | 2019/009211 | A1 | 10 January 2019 | US | 2020/0159106 | A1 | |
| | | | | paragraphs [0084]-[0088], fig. 11 | | | |
| | | | | CN | 110785703 | A | |
| | | | | KR | 10-2020-0018476 | A | |
| | | | | TW | 201907224 | A | |
| JP | 2011-35104 | A | 17 February 2011 | (Family: none) | | | |
| JP | 2008-118143 | A | 22 May 2008 | US | 2008/0248409 | A1 | |
| | | | | paragraphs [0064]-[0085], fig. 2-3 | | | |
| | | | | EP | 1498936 | A1 | |
| | | | | WO | 2003/085709 | A1 | |
| | | | | KR | 10-0815671 | B1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011176162 A
- JP 2007273678 A
- JP 2011530823 A
- JP 2019113825 A